# EUROPÄISCHE PATENTSCHRIFT

(11) **EP 0 508 171 B1**
(45) Veröffentlichungstag und Bekanntmachung des Hinweises auf die Patenterteilung: **25.06.1997**
(21) Anmeldenummer: 92104719.7
(22) Anmeldetag: 18.03.1992
(51) Int. Cl.: H03K 17/16

(54) **Getaktete Leistungsendstufe für induktive Verbraucher**
Switching mode power output stage for inductive loads
Etage de sortie de puissance à découpage pour charges inductives

(30) Priorität: 11.04.1991 EP 91105787
(43) Veröffentlichungstag der Anmeldung: 14.10.1992
(73) Patentinhaber: SIEMENS AKTIENGESELLSCHAFT, 80333 München (DE)
(72) Erfinder: Niedermeier, Ernst, Dipl.-Ing. (FH), W-8401 Hohengebraching (DE)

(56) Entgegenhaltungen:
- EP-A- 0 493 185
- GB-A- 2 140 996
- US-A- 4 661 766
- US-A- 4 949 211

## Beschreibung

Die Erfindung betrifft eine getakte Leistungsendstufe für induktive Verbraucher gemäß den Merkmalen des Patentanspruchs 1.

Zur Steuerung induktiver Verbraucher werden vielfach der geringeren Verlustleistung wegen getaktete Leistungsendstufen mit Transistoren, insbesondere MOSFET-Transistoren verwendet. Ein Nachteil solcher getakteter Endstufen ist, daß sie erhebliche elektromagnetische Störungen hervorrufen.

Eine bekannte Ursache dafür ist die durch die Taktung hervorgerufene schnelle Spannungsänderung am Verbindungspunkt zwischen Verbraucher und Schalteinrichtung. Dieser Ursache wird beispielsweise bei Schaltungen mit MOSFET's durch hochohmige Ansteuerung des Steueranschlusses mittels eines Widerstandes begegnet.

Eine weitere Ursache für die hervorgerufenen elektromagnetischen Störungen ist die durch die Taktung bewirkte schnelle Änderung des durch die Schalteinrichtung fließenden Stromes.

Diese Stromänderungsgeschwindigkeit ist abhängig von der Steilheit einer dem induktiven Verbraucher üblicherweise parallel geschalteten Freilaufdiode und von der oben genannten Spannungsänderungsgeschwindigkeit am Verbindungspunkt zwischen Verbraucher und Schalteinrichtung.

Während die Steilheit der Diode kaum beeinflußt werden kann, ist dies, wie bereits festgestellt, bei der Spannungsänderungsgeschwindigkeit mittels hochohmiger Ansteuerung der Schalteinrichtung möglich. Um die erforderliche Verringerung der Stromänderungsgeschwindigkeit zu bewirken, müßte die Spannungsänderungsgeschwindigkeit jedoch wesentlich stärker reduziert werden, als es für die Verringerung der durch sie selbst hervorgerufenen elektromagnetischen Störungen erforderlich wäre. Dabei würde aber die in der Schalteinrichtung entstehende Verlustleistung so erhöht werden, daß dadurch der durch die getaktete Ansteuerung erzielte Vorteil wieder verloren ginge.

Aus der älteren europäischen Patentanmeldung EP-A-0 493 185 ist eine getaktete Leistungsendstufe mit einem MOSFET-Schalttransistor bekannt (Figur 1), welche diese Nachteile dadurch vermeidet, daß sowohl für die differenzierte Drainspannung als auch für den differenzierten Drainstrom proportionale Spannungswerte gebildet und dem Steuertaktsignal überlagert werden.

Aus GB-A-2 140 996 ist eine getaktete Leistungsendstufe bekannt, bei der entweder der Drainstrom oder die Drainspannung differenziert und dem Steuertaktsignal überlagert wird.

In US-A-4 661 766 ist eine Leistungsendstufe beschrieben, bei der der Strom durch den Leistungstransistor und der Strom im Freilaufkreis erfaßt und mit der Steuerspannung verknüpft wird. Eine Erfassung der Spannung am Transistor sowie eine Differenzierung der erfaßten Signale ist nicht vorgesehen.

Aufgabe der vorliegenden Erfindung ist, die bekannte Leistungsendstufe, mit weniger Bauteilen bzw. Baugruppen darzustellen.

Diese Aufgabe wird durch die im Anspruch 1 genannten Merkmale gelöst.

Bei der erfindungsgemäßen Schaltung ergibt sich der Vorteil, daß ein invertierender Verstärker eingespart wird und es möglich ist, die Stromänderungsgeschwindigkeit unabhängig von der Spannungsänderungsgeschwindigkeit einzustellen und beide Größen gerade nur so steil zu machen, daß keine wesentlichen Störungen auftreten.

Nachstehend wird die Erfindung anhand der Zeichnung näher beschrieben. In der Zeichnung zeigen:
Figur 1: eine bekannte Schaltung,
Figur 2: ein Ausführungsbeispiel nach der Erfindung, und
Figur 3: ein Diagramm über den Verlauf der Spannungen und Ströme.

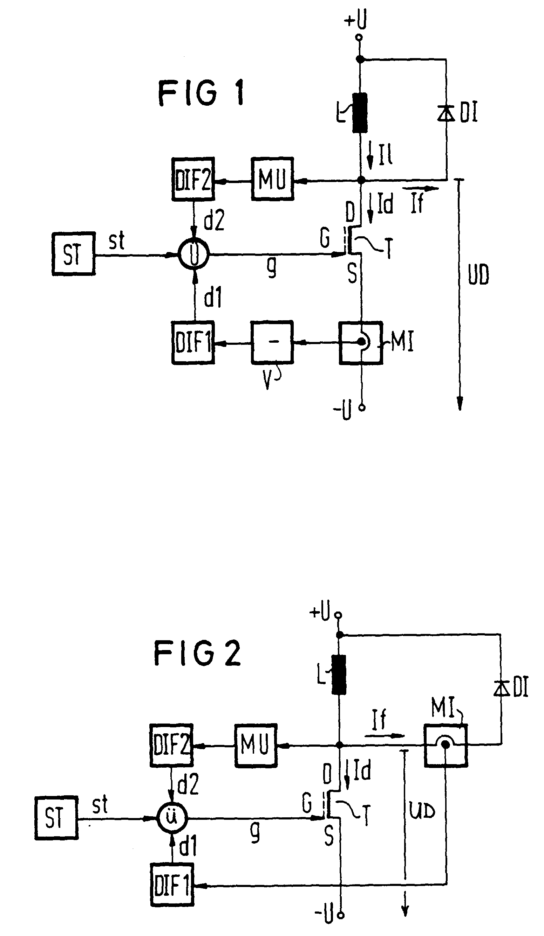

Die bekannte Schaltung einer getakteten Leistungsendstufe ist in Figur 1 dargestellt. Sie besteht aus einer an den Polen +U, -U einer nicht dargestellten Spannungsquelle liegenden Reihenschaltung eines induktiven Verbrauchers L und einer durch einen MOSFET realisierten Schalteinrichtung T. Dabei liegt der Verbraucher L zwischen dem Drainanschluß D der Schalteinrichtung T und dem positiven Pol +U der Spannungsquelle. Der Sourceanschluß S ist über eine Strommeßeinrichtung MI für den durch den Schalttransistor T fließenden Strom Id mit dem negativen Pol -U verbunden. Der Ausgang eines ein rechteckförmiges Steuertaktsignal st erzeugenden Steuergenerators ST ist über einen nicht dargestellten Widerstand mit dem Gateanschluß G des Schalttransistors T verbunden. Parallel zum Verbraucher L ist eine Freilaufdiode DI geschaltet.

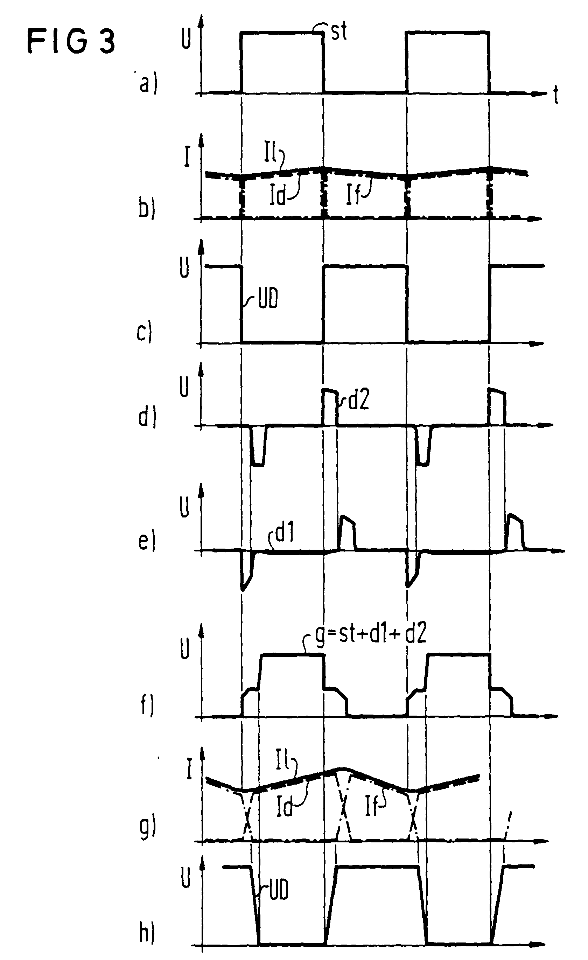

Das Steuertaktsignal st ist in Figur 3a dargestellte. Ohne eine Schattungseinrichtung zur Begrenzung der Änderungsgeschwindigkeiten von Laststrom und Lastpannung würden sich die in den Figuren 3b und 3c gezeigten signalverläufe ergeben. Figur 3b zeigt die durch das Steuertaktsignal st verursachten Ströme durch den Schalttransistor T (Id, gestrichelt), durch die Freilaufdiode DI (If, strichpunktiert) und durch die Last L (Il, durchgehende Linie). Die zwischen Drainanschluß D und dem negativen Pol - U liegende Spannung UD ist in Figur 3c dargestellt.

Aus den Figuren 3b und 3c sind steile Spannungsflanken der Spannung UD am Drainanschluß D und steile Stromflanken der Ströme Id im Schalttransistor T und If in der Freilaufdiode DI (sowie in der Spannungsquelle +U, -U) ersichtlich, welche unerwünschte elektromagnetische Störungen verursachen würden.

Der Strommeßeinrichtung MI ist ein Invertierglied V und diesem ein Differenzierglied DIF 1 nachgeschaltet, in welchem das zum Strom Id proportionale, aber invertierte Ausgangssignal der Strommeßeinrichtung MI differenziert wird. Das Ausgangssignal d1 dieses Differenziergliedes DIF 1 ist in Figur 3e dargestellt.

Außerdem ist eine Spannungsmeßeinrichtung MU vorhanden, welche die am Drainanschluß D anliegende Spannung UD mißt. Der Spannungsmeßeinrichtung MU ist ein Differenzierglied DIF 2 nachgeschaltet, welches die gemessene Spannung UD differenziert. Das Ausgangssignal d2 dieses Differenziergliedes DIF 2 ist in Figur 3d dargestellt.

Die Ausgangssignale d1 (Figur 3e) und d2 (Figur 3d) (Figur 3a) der beiden Differenzierglieder werden in einem Verknüpfungsglied Ü dem Steuertaktsignal st im Sinne einer Abschwächung bzw. Begrenzung dessen Änderungsgeschwindigkeit überlagert, beispielsweise addiert. Das Ergebnis dieser Überlagerung ist ein Ansteuersignal g (Figur 3f), welches nun anstelle des Steuertaktsignals st dem Gateanschluß G des Schalttransistors T zugeführt wird. Aufgrund dieses Ansteuersignals g sind die Anstiegs- und Abfallgeschwindigkeiten (entsprechend den mit den Differenziergliedern vorgegebenen Zeitkonstanten) der Spannungen am Schalttransistor T (Figur 3h) bzw. an der Last L und der Ströme durch den Schalttransistor T (Id Figur 3g) und die Freilaufdiode (If in Figur 3g) sowie aus der bzw. in die Spannungsquelle so verringert, daß die vorgenannten Störungen weitgehend beseitigt sind.

In Figur 2 ist ein Ausführungsbeispiel nach der Erfindung dargestellt, welches von der bekannten Schaltung nach Figur 1 dahingehend abweicht, daß die Strommeßeinrichtung MI nicht zwischen Schalttransistor T und dem negativen Pol -U der Spannungsquelle, sondern im Freilaufzweig angeordnet ist und deshalb nicht den durch den Schalttransistor T fließenden Strom Id mißt, sondern den Strom If, der durch die Freilaufdiode DI fließt. Durch diese Maßnahme kann das Invertierglied V zwischen Strommeßeinrichtung MI und Differenzierglied DIF 1 entfallen, da der Strom If im wesentlichen dem invertierten Strom Id entspricht, siehe Figur 3g.

Die Ausgangssignale dl und d2 der beiden Differenzierglieder werden, wie bei der bekannten Schaltung, in einem Verknüpfungsglied Ü mit dem Steuertaktsignal st im Sinne einer Abschwächung bzw. Begrenzung dessen Änderungsgeschwindigkeit verknüpft.

Es ist selbstverständlich möglich, die Schaltung, abweichend von den dargestellten Beispielen, auch mit npn-, pnp-Transistoren, entsprechenden MOSFET's und verpolten Spannungen aufzubauen.

## Patentansprüche

1. Getaktete Leistungsendstufe für induktive Verbraucher (L) mit einer Freilaufschaltung (DI),
mit einer an den Polen (+U; -U) einer Spannungsquelle liegenden Reihenschaltung aus dem Verbraucher (L) und einer Schalteinrichtung (T) mit kontinuierlichem Übergang zwischen Ein- und Ausschaltzustand, insbesondere eines Bipolar- oder eines MOS-Transistors,
mit einer Steuerschaltung (ST) zur Erzeugung eines Steuertaktsignals (st) für die Schalteinrichtung (T),
mit einer Strommeßeinrichtung (MI) zur Messung des durch die Freilaufschaltung (DI) fließenden Stromes (Freilaufstrom If),
mit einer Differenziereinrichtung (DIF 1) mit vorgebbarer Zeitkonstante, welche ein der zeitlichen Änderung des Ausgangssignals der Strommeßeinrichtung (MI) zugeordnetes Ausgangssignal (d1) erzeugt,
mit einer Spannungsmeßeinrichtung (MU) zur Messung der am Verbindungspunkt zwischen Verbraucher (L) und Schalteinrichtung (T) liegenden Spannung (UD) oder eines dazu proportionalen Signals,
mit einer Differenziereinrichtung (DIF 2) mit vorgebbarer Zeitkonstante, welche ein der zeitlichen Änderung des Ausgangssignals der Spannungsmeßeinrichtung (MU) zugeordnetes Ausgangssignal (d2) erzeugt, und
mit einem Vernüpfungsglied (Ü), in welchem die Ausgangssignale (d1 und d2) der Differenziereinrichtungen (DIF 1, DIF 2) dem Steuertaktsignal (st) im Sinne einer Begrenzung der Änderungsgeschwindigkeiten des Laststromes (Id) und der Lastspannung (UD) überlagert werden.

2. Leistungsendstufe nach Anspruch 1, dadurch gekennzeichnet, daß die Strommeßeinrichtung (MI) derart ausgebildet ist, daß sie eine zu dem durch die Freilaufschaltung (DI) fließenden Strom (Id; If) proportionale Spannung erzeugt.

## Claims

1. Pulsed power output stage for inductive loads (L) having a freewheeling circuit (DI),
having a series circuit which is connected to the poles (+U; -U) of a voltage source and is composed of the load (L) and a switching device (T) having a continuous transition between the on and off state, in particular a bipolar transistor or an MOS transistor,
having a control circuit (ST) for producing a control clock signal (st) for the switching device (T),
having a current measuring device (MI) for measuring the current flowing through the freewheeling circuit (DI) (freewheeling current If),
having a differentiating device (DIF 1) with a time constant which can be predetermined, which device produces an output signal (d1) which is assigned to the change with respect to time of the output signal of the current measuring device (MI),
having a voltage measuring device (MU) for measuring the voltage (UD) which is present at the junction point between the load (L) and the switching device (T), or for measuring a signal proportional to said voltage,
having a differentiating device (DIF 2) with a time constant which can be predetermined, which device produces an output signal (d2) which is assigned to the change with respect to time of the output signal of the voltage measuring device (MU), and
having a logic element (Ü) in which the output signals (d1 and d2) of the differentiating devices (DIF 1, DIF 2) are superimposed on the control clock signal (st) for the purpose of limiting the rates of change of the load current (Id) and of the load voltage (UD).

2. Power output stage according to Claim 1, characterized in that the current measuring device (MI) is designed in such a manner that it produces a voltage which is proportional to the current (Id; If) flowing through the freewheeling circuit (DI).

## Revendications

1. Etage final de puissance, à découpage de signal, pour consommateur inductif (L), comportant
un circuit de roue libre (DI),
un circuit connecté aux pôles (+U ; -U) d'une source de tension et comprenant le montage en série du consommateur (L) et d'un dispositif de commutation (T) à passage continu entre un état commandé et un état non-commandé, en particulier un transistor bipolaire ou un transistor MOS,
un circuit de commande (ST) pour produire un signal de commande découpé (st) destiné au dispositif de commutation (T),
un dispositif de mesure du courant (MI) pour mesurer le courant (courant de roue libre If) traversant le circuit de roue libre (DI),
un dispositif de différentiation (DIF 1) présentant une constante de temps prédéfinie, lequel dispositif produit un signal de sortie (d1) associé à la variation, dans le temps, du signal de sortie du dispositif de mesure du courant (MI),
un dispositif de mesure de tension (MU) pour mesurer la tension (UD) existant au point de raccordement entre le consommateur (L) et le dispositif de commutation (T), ou pour mesurer un signal proportionnel à cette tension,
un dispositif de différentiation (DIF 2) présentant une constante de temps prédéfinie, lequel dispositif produit un signal de sortie (d2) associé à la variation, dans le temps, du signal de sortie du dispositif de mesure de la tension (MU),
un opérateur logique (Ü), dans lequel les signaux de sortie (d1 et d2) des dispositifs de différentiation (DIF 1, DIF 2) sont superposés au signal de commande découpé (st) en vue de limiter les vitesses de variation du courant de charge (Id) et de la tension de charge (UD).

2. Etage final de puissance suivant la revendication 1, caractérisé en ce que le dispositif de mesure du courant (MI) est réalisé de telle façon qu'il produise une tension proportionnelle au courant (Id; If) traversant le circuit de roue libre (DI).
